# EUROPEAN PATENT APPLICATION

(11) **EP 1 558 066 A1**
(43) Date of publication of application: **27.07.2005**
(21) Application number: 04001173.6
(22) Date of filing: 21.01.2004
(51) Int. Cl.: H05K 3/34

(54) **Providing differentiated levels of solder paste on a circuit board**

(71) Applicant: Sony Ericsson Mobile Communications AB, 221 88 Lund (SE)
(72) Inventor: Fagerenius, Gustav, 24010 Dalby (SE)
(74) Representative: Dahnér, Christer

(57) **Abstract**

The present invention relates to a method and apparatus for providing differentiated levels of electrical contacting material on a circuit board (22), where a first screen (24) is placed on the circuit board, electric contacting material is placed in holes (26) provided in the first screen (24) in order to provide at least a first set of areas with contacting material (28) on the board, which areas each have a first level of contacting material, a second screen (30) is placed on the board, which second screen is provided with openings (32) aligned with and facing areas with contacting material (28) provided via the first contacting material masking screen, and electric contacting material is placed in holes (34) provided in the second screen, in order to provide a second set of areas with contacting material (36) on the board, which areas each have a second level of contacting material.

## Description

### TECHNICAL FIELD OF THE INVENTION

The present invention generally relates to the field of mounting components and other devices on circuit boards. More particularly the present invention is directed towards a method and an apparatus for providing differentiated levels of electrical contacting material on a circuit board.

### DESCRIPTION OF RELATED ART

In the process of soldering components onto circuit boards, the normal practice is to use a screen with holes that is applied over the circuit board in question. In the holes of the screen solder paste is then placed. Thereafter components are placed on top of the board and soldered by heating the whole structure in an oven and thus providing an electrical connection between contact legs of the component and contact pads of the board.

In order to provide a good soldering effect the solder has to be applied in controlled amounts. If for instance too much solder is applied for a very small circuit, the solder can smear out and create contact between two different legs of the circuit and thus render it useless. If too little solder is applied the connection between a leg of a circuit and a contact pad can be too small and no or an unstable electrical connection is provided. With the ever-decreasing size of components, the amounts needed to solder components are also getting smaller.

There can furthermore be different sized components that thus require different amounts of solder paste in order to provide a good electrical connection.

Yet another situation that is common for at least some circuit boards is that components need to be shielded, in which case shield cans are provided covering the component or components to be shielded. In order to provide good shielding these cans need to be soldered along all the circumference of the can on the board. Needless to say these cans require substantially more solder paste than a small component.

The amount of solder applied is determined by the area of the location on the board where the solder is to be applied and the height of the solder applied. However the area of the location can in many cases not be influenced for varying the amount, since this is decided by the layout of the board and solder is not to be smeared out outside that area. The only feasible way to vary the amount is in many cases thus by adjusting the height. When soldering shield cans more solder paste can furthermore be needed because of the fact that in many cases a circuit board is not exactly straight, perhaps because it has become bent because of the influence by the heat in the oven. This means that there will in such a case often be a gap between a shield can and the circuit board, which then has to be filled with extra solder paste in order to achieve the desired shielding.

In order to provide a higher level or height with solder needed for, for instance these shield cans, it is normal practice to provide an extra solder dispensing unit active after the screen printing and that is used for dispensing solder paste for the components. Such a unit is then made to move over the circuit board and apply solder paste spot by spot in order to provide the extra solder needed for the shield cans. This is a time consuming step that lowers the efficiency of the circuit board production, which thus makes the boards more expensive and lowers the throughput in the process of for instance producing a product such as a mobile phone. The production capacity is thus lowered because of this and the end product is also becoming more expensive because of this.

There is thus a need for providing an alternative and more efficient way of providing differentiated levels of solder paste for different components and devices that are to be soldered onto a circuit board.

### SUMMARY OF THE INVENTION

The present invention is directed towards solving the problem of providing an alternative and more efficient way of providing differentiated levels of electrical contacting material for different components and devices that are to be electrically contacted to a circuit board.

One object of the present invention is thus to provide a method of providing differentiated levels of electrical contacting material on a circuit board for different components and devices that are to be electrically contacted to the circuit board and that is a more efficient alternative to traditional electrical contacting material dispensing methods.

According to a first aspect of the present invention, this object is achieved by a method for providing differentiated levels of electrical contacting material on a circuit board and comprising the steps of:
placing a first contacting material masking screen on the circuit board,
placing electric contacting material in holes provided in the first contacting material masking screen, in order to provide at least a first set of areas with contacting material on the board, which areas each have a first level of contacting material,
placing a second contacting material masking screen on the board, which second material masking screen is provided with openings (32) aligned with and facing areas with contacting material provided via the first contacting material masking screen, and
placing electric contacting material in holes provided in the second screen, in order to provide a second set of areas with contacting material on the board,
which areas each have a second level of contacting material.

A second aspect of the present invention is directed towards a method including the features of the first aspect, wherein the openings of the second material masking screen are cavities arranged to receive the contacting material of the first set of areas,

A third aspect of the present invention is directed towards a method including the features of the second aspect, further comprising the steps of removing the first contacting material masking screen after placing electric contacting material in its holes and removing the second contacting material masking screen after placing electric contacting material in its holes.

A fourth aspect of the present invention is directed towards a method including the features of the second aspect, wherein the second screen has two sides and further comprising the step of removing screen material from different locations of the two sides in order to provide the holes and the cavities.

A fifth aspect of the present invention is directed towards a method including the features of the fourth aspect, wherein material in the second screen is removed from the two sides simultaneously for providing the holes and cavities.

A sixth aspect of the present invention is directed towards a method including the features of the fifth aspect, wherein screen material is removed from each side of the second screen with a depth corresponding to more than half the thickness of the second screen.

A seventh aspect of the present invention is directed towards a method including the features of the sixth aspect, wherein screen material is removed from each side of the second screen with a depth corresponding to about two thirds of the thickness of the second screen.

An eighth aspect of the present invention is directed towards a method including the features of the fourth aspect, wherein a location on a first side is aligned with a location on a second side in order to provide a hole.

A ninth aspect of the present invention is directed towards a method including the features of the eighth aspect, wherein there is no aligned location on one side corresponding to a location on the other side in order to provide a cavity.

A tenth aspect of the present invention is directed towards a method including the features of the fourth aspect, wherein the removal of screen material is performed by placing a photo resist material on both sides of the second screen, printing a pattern on the photo resist material on both sides of the second screen, etching away screen material together with non-printed parts of the photo resist material, and removing the remaining photo resist material.

An eleventh aspect of the present invention is directed towards a method including the features of the first aspect, further comprising the steps of placing devices on the board and electrically connecting the devices to the board using the two sets of areas with contacting material.

Another object of the present invention is to provide an apparatus for providing differentiated levels of electrical contacting material on a circuit board for different components and devices that are to be electrically contacted to the circuit board and that is a more efficient alternative to traditional electrical contacting material dispensing devices.

According to a twelfth aspect of the present invention this object is achieved by an apparatus for providing differentiated levels of electrical contacting material on a circuit board and comprising:
at least a first screen printer arranged to:
   place a first contacting material masking screen on the circuit board, and
   place electric contacting material in holes provided in the first contacting material masking screen, in order to provide at least a first set of areas with contacting material on the board, which areas each have a first level of contacting material,
wherein one screen printer is arranged to:
place a second contacting material masking screen on the board, which second material masking screen is provided with openings (32) aligned with and facing areas with contacting material provided via the first contacting material masking screen, and
place electric contacting material in holes provided in the second screen in order to provide a second set of areas with contacting material on the board, which areas each have a second level of contacting material.

A thirteenth aspect of the present invention is directed towards an apparatus including the features of the twelfth aspect, comprising a second screen printer arranged to place the second contacting material masking screen and place electric contacting material in its holes.

A fourteenth aspect of the present invention is directed towards an apparatus including the features of the thirteenth aspect, wherein the openings of the second material masking screen are cavities arranged to receive the contacting material of the first set of areas,

A fifteenth aspect of the present invention is directed towards an apparatus including the features of the fourteenth aspect, wherein the first screen printer is further arranged to remove the first contacting material masking screen after placing electric contacting material in its holes and the second screen printer is further arranged to remove the second contacting material masking screen after placing electric contacting material in its holes.

A sixteenth aspect of the present invention is directed towards an apparatus including the features of the fourteenth aspect, wherein the second screen has two sides and further comprising a screen providing unit arranged to remove screen material from different locations of the two sides in order to provide the holes and the cavities.

A seventeenth aspect of the present invention is directed towards an apparatus including the features of the sixteenth aspect, wherein the screen providing unit is arranged to remove screen material in the second screen from the two sides simultaneously for providing the holes and cavities.

An eighteenth aspect of the present invention is directed towards an apparatus including the features of the seventeenth aspect, wherein the screen providing unit is arranged to remove screen material from each side of the second screen with a depth corresponding to more than half the thickness of the second screen.

A nineteenth aspect of the present invention is directed towards an apparatus including the features of the eighteenth aspect, wherein the screen providing unit is arranged to remove screen material from each side of the second screen with a depth corresponding to about two thirds of the thickness of the second screen.

A twentieth aspect of the present invention is directed towards an apparatus including the features of the sixteenth aspect, wherein a location on a first side is aligned with a location on a second side in order to provide a hole.

A twenty-first aspect of the present invention is directed towards an apparatus including the features of the twentieth aspect, wherein there is no aligned location on one side corresponding to a location on the other side in order to provide a cavity.

A twenty-second aspect of the present invention is directed towards an apparatus including the features of the sixteenth aspect, wherein the screen providing unit comprises a photo resist providing unit arranged to place a photo resist material on both sides of the second screen and to print a pattern on the photo resist material on both sides of the second screen, an etching unit arranged to remove the screen material by etching away screen material together with non-printed parts of the photo resist material and a screen bath unit arranged to remove the remaining photo resist material.

A twenty-third aspect of the present invention is directed towards an apparatus including the features of the twelfth aspect, further comprising a pick and placing unit for placing electrical devices on the board and an electrical connection providing unit for electrically connecting the devices to the board using the two sets of areas with contacting material.

The invention has the following advantages. With the invention it is possible to provide differentiated levels of electrical contacting material to a circuit board in an efficient way, which is compatible with mass production of circuit boards with connected components. The differentiated levels enables the consideration of connecting components that need different levels, for instance because of size differences and also enables securing a good shielding effect of shield cans for instance because the board gets bent when electrically connecting the components. An extra electrical contacting material dispensing unit dispensing additional electrical contacting material at all selected locations is not necessary, which would be a bottleneck in the production, because of the need to go over the board with this unit. This makes the production faster and also lowers the cost of production of each circuit board. It is furthermore hard to control the preciseness of the dispensing of electrical contacting material with this type of unit. The apparatus and method according to the invention furthermore allows the provision of larger shield cans, which simplifies the mounting and lowers the associated costs even further.

It should be emphasized that the term "comprises/comprising" when used in this specification is taken to specify the presence of stated features, integers, steps or components, but does not preclude the presence or addition of one or more other features, integers, steps, components or groups thereof.

### BRIEF DESCRIPTION OF THE DRAWINGS

The present invention will now be described in more detail in relation to the enclosed drawings, where:
fig. 1 shows a block schematic of an apparatus for providing different levels of solder paste according to the present invention,
fig. 2A - F schematically show sectional views of a circuit board with applied first and second screens and solder paste for providing differentiated solder paste levels,
fig. 3 shows a flow chart of a method of providing differentiated levels of solder paste according to the present invention,
fig. 4 shows a block schematic of a unit for providing a second screen according to the invention, and
fig. 5 shows a flow chart of a method of producing a second screen according to the present invention.

### DETAILED DESCRIPTION OF EMBODIMENTS

In the process of placing and connecting electrical components on a circuit board, controlled amounts of electrical contacting material in the form of solder paste is used. This amount is tightly controlled so that enough solder paste is provided for soldering the leg of a component to a contact pad of a circuit board, while not being smeared out and endangering a contact between other legs of the same or other components. In many types of applications, like for instance in the field of mobile phones, there are needed shield cans in order to shield components used from for instance radiation provided by antennas. These shield cans often need more solder than the component in order to provide a good shielding effect. This is especially the case if the board is bent or curved, which can be caused by the heat in an oven for soldering. In this case the shield can would need extra solder paste in order to guarantee a good shielding. There is thus needed a way to provide differentiated amounts of solder paste in the process of soldering components to a circuit board.

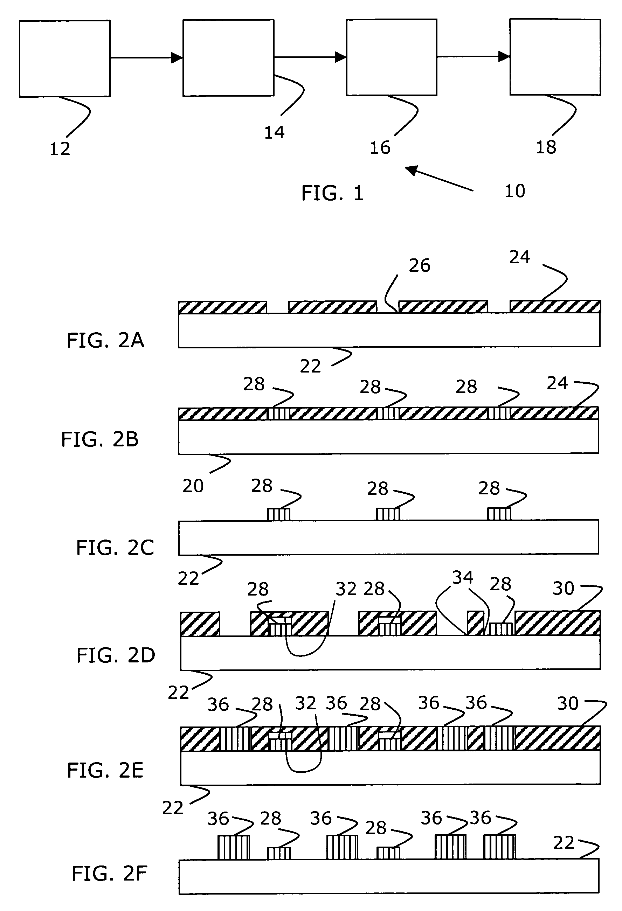

In order to solve this, an apparatus and a method according to the invention for providing differentiated levels of electrical contacting material on a circuit board are provided. The apparatus 10 is shown in a block schematic in fig. 1 and comprises a first screen printer 12, which is connected to a second screen printer 14. The second screen printer 14 is connected to pick and placing unit 16, which in turn is connected to an electrical connection providing unit 18 in the form of an oven.

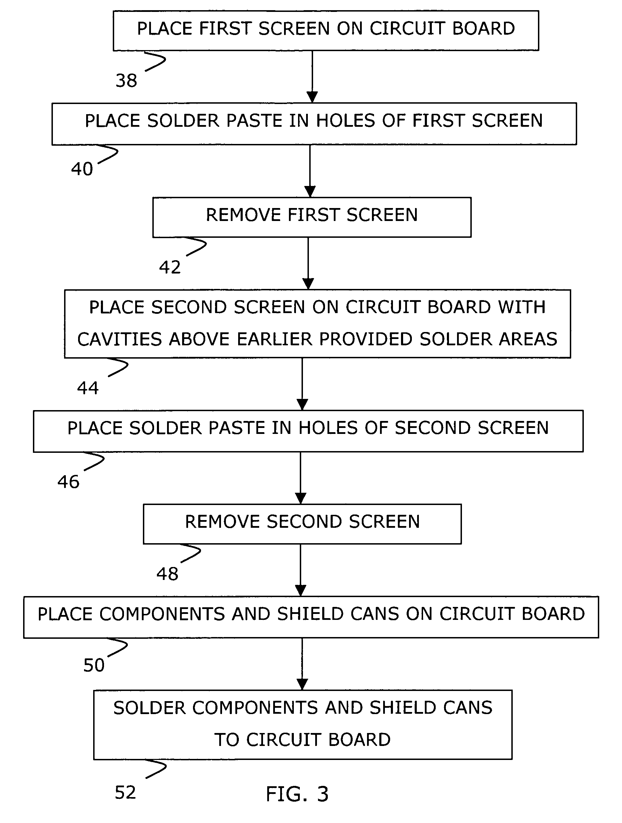

The general functioning of the device in fig. 1 will now be described in relation to fig, 2A - F, which show sectional views of a circuit board in and after the two screen printers 12 and 14 as well as to fig. 3, which shows a flow chart of a method according to the invention. The description will in the following also be made in relation to one circuit board. It should however be realised that the invention is suitable for and of best effect in the mass production of circuit boards with components on them.

The method starts with the first screen printer 12 receiving a circuit board 22. In the first screen printer a first metallic contacting material masking screen 24 is placed on top of this board 22, step 38. The screen is provided with a number of through holes 26, i.e. a number of holes going through the topside of screen 24 to the circuit board 22. Each hole 26 is aligned with and provided straight above a contact pad on the board, i.e. a pad provided for contacting the leg of a circuit. The sizes of the holes are furthermore all sized such that they each provide an area with a controlled first amount of solder material. The height or the level of the solder material is defined by the thickness of the first screen 24. Thus the thickness of the first screen determines the first level of solder paste for these areas. The board 22 with the applied first screen 24 is schematically shown in fig. 2A. Hereafter the first screen printer 12 places solder paste 28 in the holes of the first screen, step 40, where the screen 24 with the paste 28 in the holes on top of the circuit board 22 is shown in fig. 2B. Thereafter the first screen 24 is removed in the first screen printer 12, step 42. The board 22 now therefore has a first set of areas each having a first level of solder paste 28 provided on the contact pads for the circuits to be provided, where the amounts are controlled by the dimensions of the holes and the thickness of the first screen. This board is shown in fig. 2C.

The circuit board 22 now leaves the first screen printer 12 and is provided to the second screen printer 14. In the second screen printer 14 a second contacting material masking screen 30, preferably of the same material as the first screen, is placed on the circuit board 22, step 44. The second screen 30 has openings in the form of cavities 32 provided on its bottom side, which cavities 32 thus face the circuit board 22. These cavities 32 are furthermore provided in positions corresponding to and facing the positions of the first areas 28 of solder paste. The cavities 32 are therefore dimensioned for receiving the solder paste 28 of these areas when the second screen is pressed onto the circuit board. The second screen 30 is preferably twice as thick as the first screen and is furthermore provided with through holes 34 arranged and sized for receiving a second amount of solder paste, where the size of the holes 34 are dimensioned for providing enough solder paste for providing good shielding of a shield can that is to be soldered to the circuit board. The thickness of the second screen 30 determines a second level of solder paste in order to take account of for instance the uneven structure of the board. This is furthermore shown in fig. 2D. As is apparent from fig. 2D, a hole 34 may be provided around an area already containing a first level of solder paste 28. Hereafter solder paste is placed in the holes of the second screen 30, step 46, in order provide second areas with a second level of solder paste 36, which is shown in fig. 2E. Thereafter the second screen is removed in the second screen printer, step 48, such that now the circuit board 22 is provided with the first set of areas having the first level of solder paste 28 and the second set of areas having the second level of solder paste 36, which is preferably the double level as compared with the first level. This board is shown in fig. 2F. The area having the first level of solder paste, which was provided in a hole of the second screen now also has the second level of solder paste.

Thereafter the board leaves the second screen printer and is provided to the pick and place unit 16, which places components on the circuit board and then places shield cans above the components that need shielding, step 50. Thereafter the circuit board is transported to the oven 18, where the components and shield cans are soldered to the circuit board in order to provide electrical connections to them, step 52.

There are several advantages associated with the described apparatus and method. With this apparatus and this method it is possible to provide differentiated levels of solder paste to a circuit board in an efficient way, which is compatible with mass production of circuit boards with soldered components. The differentiated levels enables the consideration of soldering components that need different levels, for instance because of size differences and also enables securing a good shielding effect of shield cans for instance because the board gets bent in the oven. An extra solder dispensing unit dispensing additional solder paste at all selected locations is not necessary, which would be a bottleneck in the production, because of the need to go over the board with this unit. This makes the production faster and also lowers the cost of production of each circuit board. It is furthermore hard to control the preciseness of the dispensing of solder paste with this type of unit. Because of the cavities in the second screen, the solder having the first levels will furthermore not be smeared out on the circuit board. The apparatus and method according to the invention furthermore allows the provision of larger shield cans, which simplifies the mounting and lowers the associated costs even further.

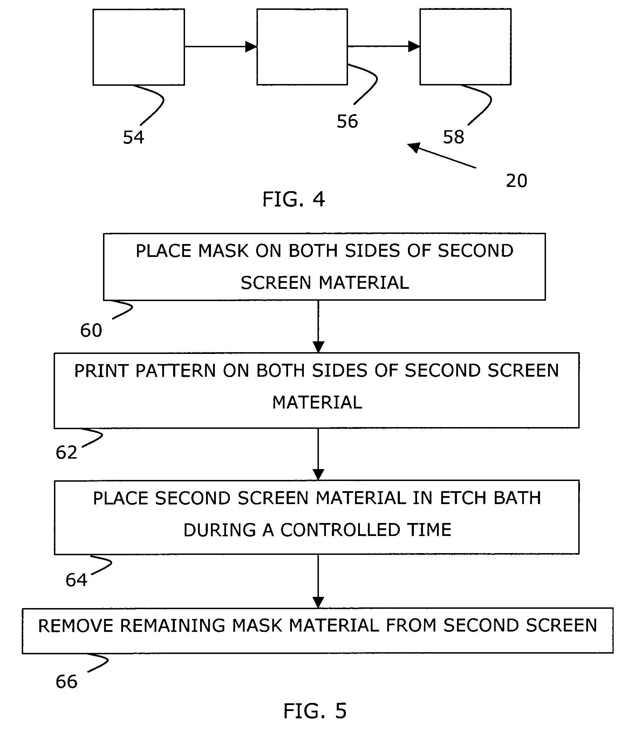

As mentioned above the second screen has cavities on the underside. Another aspect of the present invention will now be described which is directed towards providing this second screen that is used in the second screen printer. This second aspect will now be described with reference being made to fig. 4, which shows a block schematic of a screen providing unit 20 and to fig. 5 showing a flow chart of the steps performed in producing the second screen. The screen providing unit may form part of the screen printing device. It should however be realised that it can be provided as a separate entity.

The screen providing unit 20 comprises a photo resist providing unit 54 which places a photo resist or mask on both sides of a second screen material, which material is preferably sheet metal, step 60. The photo resist providing unit thereafter prints a pattern on both sides of the second screen material, step 62. The pattern is then provided on areas that are not to receive cavities and holes and consequently the non-printed areas are to receive the cavities and holes. The non-printed areas on the top side are aligned with non-printed areas of the bottom side of the screen material in order to enable the provision of a through hole, while some non-printed areas on the bottom side of the second screen material do not have any corresponding non-printed areas on the topside, i.e. they are aligned with printed areas on the topside in order to provide the cavities. Thereafter the second screen material is placed in an etching unit 56 or etch bath for a controlled time, step 64. The time is controlled such that non-printed areas are etched to a depth of more than half and preferably 2/3 of the screen thickness. This simultaneous etching from both sides of the screen material provides a well defined through hole. The etching to a depth of 2/3 of the thickness ensures a cavity that easily can receive the first areas of solder paste without smearing on the circuit board. After this etching the second screen material is placed in a screen bath unit 58 where the remaining printed mask material is removed, step 66, such that a finalised second screen is provided. This second screen is then used in the second screen printer shown in fig. 1.

There are a number of variations that can be made to the present invention apart from the ones already mentioned. The second screen can be put directly on the first screen when the first levels of solder material have been placed, i.e. without removing the first screen but after removal of superfluous solder paste. The first screen would then include first holes with dimensions for receiving the first amount of solder material and second holes with dimensions for receiving parts of the second amount of solder material, while the second screen would include holes having dimensions for receiving the remainder of the second amount of solder material, being aligned with and facing the second holes of the first screen. The holes of the second screen here form the openings that are aligned with the second holes of the first screen. With this realisation of the two screens, the two steps of screen printing can then furthermore be performed in one screen printer, while still ensuring the same end result. It is furthermore possible to provide more than two screens in order to take account of more differentiated levels of solder paste. The described method of providing a second screen is just one preferred embodiment. Other ways of providing through holes and cavities than the way described are also possible such as for instance through milling holes in two separate layers of material and then joining the layers to each other. The screens are preferably provided in the form of sheet metal although other materials can be contemplated. Other sizes of the cavities and holes than the ones described and other relationships between the screen thicknesses than the relationship described can of course also be contemplated. A hole can for instance be elongated for providing for instance a line that a shield can is to be soldered to. Therefore the invention is only to be limited by the following claims.

## Claims

1. Method of providing differentiated levels of electrical contacting material on a circuit board (22) comprising the steps of:
placing a first contacting material masking screen (24) on the circuit board, (step 38),
placing electric contacting material in holes (26) provided in the first contacting material masking screen (24), (step 40), in order to provide at least a first set of areas with contacting material (28) on the board, which areas each have a first level of contacting material,
placing a second contacting material masking screen (30) on the board, (step 44), which second material masking screen is provided with openings (32) aligned with and facing areas with contacting material (28) provided via the first contacting material masking screen, and
placing electric contacting material in holes (34) provided in the second screen, (step 46), in order to provide a second set of areas with contacting material (36) on the board, which areas each have a second level of contacting material.

2. Method according to claim 1, wherein the openings of the second contacting material masking screen are cavities (32) arranged to receive the contacting material of the first set of areas.

3. Method according to claim 2, further comprising the steps of removing the first contacting material masking screen after placing electric contacting material in its holes (step 42) and removing the second contacting material masking screen after placing electric contacting material in its holes (step 48).

4. Method according to claim 2 or 3, wherein the second screen has two sides and further comprising the step of removing screen material from different locations of the two sides in order to provide the holes and the cavities (step 64).

5. Method according to claim 4, wherein material in the second screen is removed from the two sides simultaneously for providing the holes and cavities.

6. Method according to claim 5, wherein screen material is removed from each side of the second screen with a depth corresponding to more than half the thickness of the second screen.

7. Method according to claim 6, wherein screen material is removed from each side of the second screen with a depth corresponding to about two thirds of the thickness of the second screen.

8. Method according to any of claims 4 - 7, wherein a location on a first side is aligned with a location on a second side in order to provide a hole.

9. Method according to claim 8, wherein there is no aligned location on one side corresponding to a location on the other side in order to provide a cavity.

10. Method according to any of claims 4 - 9, wherein the removal of screen material is performed by placing a photo resist material on both sides of the second screen, (step 60), printing a pattern on the photo resist material on both sides of the second screen, (step 62), etching away screen material together with non-printed parts of the photo resist material, (step 64), and removing the remaining photo resist material, (step 66).

11. Method according to any previous claim, further comprising the steps of placing devices on the board, (step 50), and electrically connecting the devices to the board using the two sets of areas with contacting material, (step 52).

12. Apparatus (10) for providing differentiated levels of electrical contacting material on a circuit board and comprising:
at least a first screen printer (12) arranged to:
place a first contacting material masking screen (24) on the circuit board (22), and
place electric contacting material in holes (26) provided in the first contacting material masking screen, in order to provide at least a first set of areas with contacting material (28) on the board, which areas each have a first level of contacting material,
wherein one screen printer (14) is arranged to:
place a second contacting material masking screen (30) on the board,
which second material masking screen is provided with openings (32) aligned with and facing areas with contacting material (28) provided via the first contacting material masking screen, and
place electric contacting material in holes (34) provided in the second screen in order to provide a second set of areas with contacting material (36) on the board, which areas each have a second level of contacting material.

13. Apparatus according to claim 12, comprising a second screen printer (14) arranged to place the second contacting material masking screen and place electric contacting material in its holes.

14. Apparatus according to claim 13, wherein the openings of the second material masking screen are cavities (32) arranged to receive the contacting material of the first set of areas.

15. Apparatus according to claim 14, wherein the first screen printer is further arranged to remove the first contacting material masking screen after placing electric contacting material in its holes and the second screen printer is further arranged to remove the second contacting material masking screen after placing electric contacting material in its holes.

16. Apparatus according to claim 14 or 15, wherein the second screen has two sides and further comprising a screen providing unit (20) arranged to remove screen material from different locations of the two sides in order to provide the holes and the cavities.

17. Apparatus according to claim 16, wherein the screen providing unit is arranged to remove screen material in the second screen from the two sides simultaneously for providing the holes and cavities.

18. Apparatus according to claim 17, wherein the screen providing unit is arranged to remove screen material from each side of the second screen with a depth corresponding to more than half the thickness of the second screen.

19. Apparatus according to claim 18, wherein the screen providing unit is arranged to remove screen material from each side of the second screen with a depth corresponding to about two thirds of the thickness of the second screen.

20. Apparatus according to any of claims 16 - 19, wherein a location on a first side is aligned with a location on a second side in order to provide a hole.

21. Apparatus according to claim 20, wherein there is no aligned location on one side corresponding to a location on the other side in order to provide a cavity.

22. Apparatus according to any of claims 16 - 21, wherein the screen providing unit comprises a photo resist providing unit (54) arranged to place a photo resist material on both sides of the second screen and to print a pattern on the photo resist material on both sides of the second screen, an etching unit (56) arranged to remove the screen material by etching away screen material together with non-printed parts of the photo resist material and a screen bath unit (58) arranged to remove the remaining photo resist material.

23. Apparatus according to any of claims 12 - 22, further comprising a pick and placing unit (16) for placing electrical devices on the board and an electrical connection providing unit (18) for electrically connecting the devices to the board using the two sets of areas with contacting material.
